# EUROPÄISCHE PATENTSCHRIFT

(11) **EP 0 934 545 B1**
(45) Veröffentlichungstag und Bekanntmachung des Hinweises auf die Patenterteilung: **23.01.2002**
(21) Anmeldenummer: 97945797.5
(22) Anmeldetag: 27.10.1997
(51) Int. Cl.: G02B 27/09, H01S 5/02

(54) **OPTISCHE ANORDNUNG ZUR SYMMETRIERUNG DER STRAHLUNG VON LASERDIODEN**
OPTICAL ARRAY FOR SYMMETRIZATION OF LASER DIODE BEAMS
DISPOSITIF OPTIQUE DE SYMETRISATION DU FAISCEAU DE DIODES LASER

(30) Priorität: 28.10.1996 DE 19645150
(43) Veröffentlichungstag der Anmeldung: 11.08.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: GÖRING, Rolf, D-07749 Jena (DE); SCHREIBER, Peter, D-07749 Jena (DE); POSSNER, Torsten, D-07747 Jena (DE)
(74) Vertreter: Pfenning, Meinig & Partner
(86) Internationale Anmeldenummer: DE9702573
(87) Internationale Veröffentlichungsnummer: WO9819202

(56) Entgegenhaltungen:
- EP-A- 0 484 276
- WO-A-96/02013
- DE-A- 4 438 368
- US-A- 5 513 201
- PATENT ABSTRACTS OF JAPAN vol. 096, no. 002, 29.Februar 1996 & JP 07 287105 A (NIPPON STEEL CORP), 31.Oktober 1995,
- PATENT ABSTRACTS OF JAPAN vol. 010, no. 358 (P-522), 2.Dezember 1986 & JP 61 156219 A (FUJI PHOTO FILM CO LTD), 15.Juli 1986,
- R. GORING, P SCHREIBER, T POSSNER: "Micropotical beam transformation system for high-power laser diode bars with efficient brightness conservation" PROCEEDINGS OF SPIE, THE INTERNATIONAL SOCIETY FOR OPTICAL ENGINEERING, MINIATURIZED SYSTEMS WITH MICROOPTICS AND MICROMECHANICS II 10-12 FEBRUARY 1997, Bd. 3008, SAN JOSE, Seiten 202-210, XP002057348

## Beschreibung

Die Erfindung betrifft eine optische Anordnung zur Symmetrierung der Strahlung von Laserdioden nach dem Oberbegriff des Hauptanspruchs.

Zur Herstellung von Hochleistungslaserdiodenanordnungen werden eine Mehrzahl von Laserdioden in fester Zuordnung zu sogenannten Laserdiodenbarren nebeneinander angeordnet. Derartige Laserdiodenbarren mit optischen Ausgangsleistungen im Bereich bis etwa 30 W bestehen üblicherweise aus mehreren in einer Reihe angeordneten Laserdioden als Einzelemittern mit einer geometrischen Abmessung der abstrahlenden Fläche zwischen etwa 50 x 1 µm und etwa 200 x 1 µm, wobei die lineare Anordnung dieser Emitter stets in Richtung ihrer größten Ausdehnung erfolgt. Die Ausgangsstrahlung dieser Laserdiodenbarren ist extrem unsymmetrisch. Für die meisten praktischen Anwendungen solcher Laserdiodenbarren, zum Beispiel zum Pumpen von Festkörperlasern, für Zwecke der Materialbearbeitung und medizinische Zwecke wird ein symmetrisches Bündel hoher Strahldichte benötigt. Für einen breiten Einsatz von Hochleistungsdiodenlasern in den genannten Gebieten sind somit möglichst kompakte optische Systeme zur Strahlsymmetrierung erforderlich.

Es sind Anordnungen zur Symmetrierung der Strahlung von Hochleistungslaserdioden bekannt, die beispielsweise spezielle Strahlendrehelemente in Form von Prismen verwenden, wodurch die von den einzelnen Emittern ausgesandten Strahlenbündel räumlich typischerweise um 90° gedreht werden (US 5 168 401, EP 0 484 276). In einer anderen Anordnung durchläuft die Ausgangsstrahlung der Laserdioden ein System aus zwei schwach zueinander geneigten hochreflektierenden Flächen derart, daß sich am Ausgang dieses Systems eine geeignete Rekonfigurierung des Laserdiodenbündels ergibt (WO 95/15510). In allen Fällen wird ein weitgehend symmetrisches Ausgangsbündel geschaffen, welches sich gut fokussieren läßt.

Nachteilig an diesen bekannten Systemen ist insbesondere die Kompliziertheit der verwendeten mikrooptischen Elemente, wobei dies insbesondere für die Strahlendrehung gilt, bei der eine Realisierung für größere Emitterzahlen im Laserdiodenbarren als äußerst schwierig erscheint, der hohe Justieraufwand des Gesamtsystems und die fehlende Möglichkeit zur preisgünstigen Herstellung solcher Systeme.

Ausgehend vom Stand der Technik liegt der Erfindung die Aufgabe zugrunde, eine optische Anordnung zur Symmetrierung der Strahlung einer Mehrzahl von in fester Zuordnung nebeneinander angeordneten Laserdioden zu schaffen, die unter Verwendung vergleichsweise einfacher mikrooptischer Komponenten die Ausgangsstrahlung ohne Strahldichteneinbußen bei verbessertem optischen Wirkungsgrad und gleichzeitiger Verringerung der Abmessungen der Anordnung transformiert. Diese Aufgabe wird erfindungsgemäß durch die kennzeichnenden Merkmale des Hauptanspruchs in Verbindung mit den Merkmalen des Oberbegriffs gelöst.

Dadurch, daß eine Mikrozylinderlinse mit ausreichend großer Isoplanasie in geneigter Orientierung zum Laserdiodenbarren angeordnet wird, das heißt um die als z-Achse bezeichnete optische Achse gekippt wird, erhalten die Ausgangsbündel der Einzelemitter jeweils unterschiedliche Abstrahlwinkel und werden somit in genügend großem Abstand hinter der Linse in der gewünschten Richtung senkrecht zu der Richtung der linearen Anordnung der Einzelemitter getrennt. Durch ein nachgeschaltetes optisches Ablenkelement, das im weiteren als Direktionselement bezeichnet wird, wird die Ausgangsstrahlung der einzelnen Laserdioden bzw. Emitter in der Richtung der linearen Anordnung der einzelnen Laserdioden so umgelenkt, daß in einem vorgegebenen Abstand hinter dem Direktionselement die Bündelschwerpunkte in dieser Richtung zusammenfallen. Dadurch, daß weiterhin hinter dem Direktionselement ein zweites Ablenkelement, im weiteren als Redirektionselement bezeichnet, angeordnet ist, das die Ausgangsstrahlbündel der einzelnen Laserdioden derart umlenkt, daß die vom Direktionselement erzeugten Ablenkwinkel wieder kompensiert werden, wird insgesamt eine einfache und kostengünstige Anordnung zur Strahlformung zur Verfügung gestellt, die gegenüber dem Stand der Technik eine verbesserte optische Effizienz aufweist.

Es sind keine strahldrehenden Elemente notwendig, die Symmetrierung der Abstrahlung wird durch die mehrfache Ablenkung erreicht. Die Segmentierung der optischen Abbildung wird durch die lateralen Abstände der Einzelemitter und das darauf abgestimmte Redirektionselement bewirkt, wobei die Abstände gering gehalten werden können, so daß eine hohe Belegungsdichte des Laserdiodenbarrens ermöglicht wird.

Durch die in den Unteransprüchen angegebenen Maßnahmen sind vorteilhafte Weiterbildungen und Verbesserungen möglich.

Ein Ausführungsbeispiel ist in der Zeichnung dargestellt und wird in der nachfolgenden Beschreibung näher erläutert. Es zeigen:
- Fig. 1: die optische Anordnung zur Symmetrierung der Strahlung einer Mehrzahl von Laserdioden in zwei verschiedenen Ebenen mit den Strahlengängen,
- Fig. 2: die optischen Strahlengänge in den zwei Ebenen für eine in der Mitte des Laserdiodenbarrens angeordnete Laserdiode, und
- Fig. 3: die Strahlengänge einer am Rand des Laserdiodenbarrens angeordneten Laserdiode.

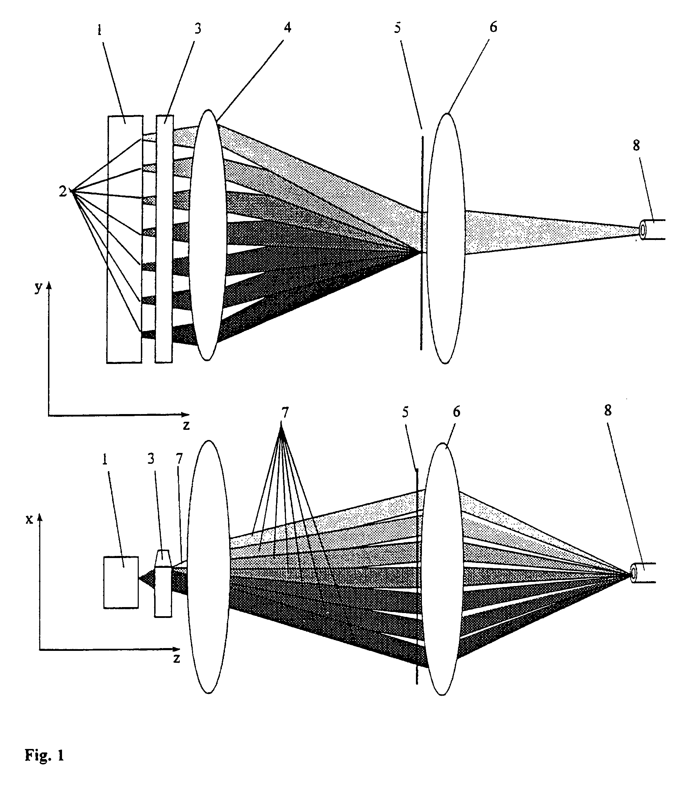

Bei der in Fig. 1 dargestellten optischen Anordnung zur Strahlformung ist mit 1 ein Hochleistungs-Laserdiodenbarren bezeichnet. Der Laserdiodenbarren 1 weist eine Mehrzahl von in y-Richtung nebeneinander angeordneten einzelnen Laserdioden oder Einzelemitter 2 auf, die einen festen Abstand zueinander haben. Ein typischer Laserdiodenbarren 1 besitzt in der Richtung der Nebeneinanderordnung (y-Richtung) eine Abmessung von 10 mm, wobei die Einzelemitter, zum Beispiel 16, in einer Linie angeordnet sind. Die Abmessung der Emitter in y-Richtung variiert zwischen etwa 50 µm und 200 µm und ist abhängig vom konkreten Laserdiodentyp. Die Divergenz der Ausgangsstrahlung jeder einzelnen Laserdiode ist in der in Fig. 1 oben dargestellten y-z-Ebene relativ gering, der halbe Öffnungswinkel beträgt etwa 6°. In der zu der y-Richtung senkrechten Richtung (x-Richtung) betragen die Abmessungen der einzelnen Laserdioden etwa 1 µm, wobei die Größe durch die Epitaxie vorgegeben ist. Entsprechend ist die Divergenz der Ausgangsstrahlung in der in Fig. 1 unten dargestellten x-z-Ebene deutlich größer und der halbe Öffnungswinkel ist etwa 30°. Zwischen den einzelnen Laserdioden bzw. Emitter befinden sich Bereiche, in denen keine Strahlung abgestrahlt wird.

Die aufgrund der unterschiedlichen Abmessungen in x- und y-Richtung auftretende extreme Unsymmetrie der Ausgangsstrahlung ist für viele Anwendungen ungünstig. Eine Symmetrierung der Ausgangsstrahlung erfordert eine Umordnung der Strahlbündel der einzelnen Laserdioden derart, daß sie in der ursprünglich stark divergenten Richtung (x-Richtung) linear angeordnet sind.

Parallel zu dem Laserdiodenbarren 1 ist eine Kollimator-Mikrozylinderlinse 3 angeordnet, die, wie in Fig. 1 unten angedeutet ist, um die z-Achse, die die optische Achse darstellt, gekippt ist. Die Mikrozylinderlinse 3 ist so ausgebildet, daß sie eine ausreichend große Isoplanasie aufweist. Die jeweiligen Ausgangsstrahlbündel 7 der einzelnen Laserdioden 2 werden jeweils für sich kollimiert, erhalten durch die Neigung der Mikrozylinderlinse 3 unterschiedliche Abstrahlwinkel bezüglich der ursprünglichen optischen Achse (z-Achse in Fig. 1) und werden so, in der x-Richtung gesehen, in der Höhe versetzt bzw. getrennt. Die Strahlung in der y-z-Richtung der einzelnen Laserdioden 2 geht unverändert durch die Zylinderlinse hindurch. Als Kollimator-Mikrozylinderlinse kann eine gradientenoptische Mikrozylinderlinse mit einem eindimensionalen oder auch zweidimensionalen Brechzahlprofil verwendet werden. Auch können Asphären-Mikrozylinderlinsen eingesetzt werden, wobei hier jedoch bei einer außeraxialen Anordnung zu einer Verschlechterung der Kollimation führt. Weiterhin ist die Verwendung einer Fresnel-Zylinderlinse, einer Plankonvex- oder Biokonvexlinse einschließlich Faserlinse (runder Querschnitt) sowie einer Mehrkomponenten-Zylinderoptik, bestehend aus zwei oder mehreren der oben beschriebenen Einzellinsen denkbar.

Hinter der Mikrozylinderlinse 3 ist ein optisches Direktionselement 4, das beispielsweise als Achromat ausgebildet sein kann, angeordnet. Anstelle des Achromaten können auch andere Linsen verwendet werden, beispielsweise eine Bikonvex- oder Plankonvexlinse mit sphärischen oder asphärischen Oberflächen oder eine Bikonvex- oder Plankonvex-Zylinderlinse. Wie aus Fig. 1 oben zu erkennen ist, werden die Ausgangsstrahlenbündel 7 der einzelnen Laserdioden 2 in der Richtung der linearen Anordnung der einzelnen Laserdioden 2 im Barren 1, das heißt in der y-z-Ebene so umgelenkt, daß in einem bestimmten Abstand hinter dem Direktionselement 4 die Bündelschwerpunkte zusammenfallen, d.h., in der y-Richtung liegen in dem vorbestimmten Abstand die Strahlbündel übereinander. In der x-z-Ebene werden die Strahlenbündel nur geringfügig beeinflußt.

In dem vorbestimmten Abstand, bei dem gemäß Fig. 1 oben die Schwerpunkte (Zentroid) der einzelnen Strahlenbündel zusammenfallen, ist ein optisches Redirektionselement 5 angeordnet, das die Strahlbündel der einzelnen Laserdioden so ablenkt, daß die durch das Direktionselement 4 in der y-z-Ebene erzeugten unterschiedlichen Einfallswinkel korrigiert werden, d.h., daß die vom Direktionselement erzeugten Neigungswinkel zur z-Achse bzw. optischen Achse wieder kompensiert werden. Das Redirektionselement 5 muß für die Erzielung der unterschiedlichen Ablenkungswinkel linear angeordnete unterschiedliche Ablenkbereiche aufweisen und kann beispielsweise aus schmalen prismatischen Körpern bestehen. Die Realisierung eines solchen Redirektionselementes 5 ist jedoch recht aufwendig. Eine einfachere Ausführungsform besteht in einem Gitterarray mit ablenkenden Gittern. Das Redirektionselement 5 kann auch als Spiegelfeld ausgebildet sein.

Nach dem Redirektionselement 5 verlaufen die Strahlbündel der einzelnen Laserdioden 2 in bezug auf die y-z-Ebene in gleicher Richtung, das heißt die Strahlung der einzelnen Laserdioden 2 liegt entsprechend Fig. 1 oben hinter dem Redirektionselement übereinander. In der x-z-Ebene entsprechend Fig. 1 unten behalten die einzelnen Bündel 7 weiter ihre zueinander divergenten Richtungen bei.

Dem Redirektionselement 5 ist eine Fokussieroptik 6 nachgeschaltet, die beispielsweise aus Achromaten bestehen kann, und die Strahlbündel 7 der einzelnen Laserdioden 2 lassen sich nun sowohl in der y-z-Ebene als auch in der x-z-Ebene sehr gut in einen weitestgehend symmetrischen Strahlfleck geringer Abmessung konzentrieren, wie aus Fig. 1 zu erkennen ist. Diese Strahlung kann in dem dargestellten Ausführungsbeispiel dann mit hoher Effizienz in eine optische Faser 8 eingekoppelt werden.

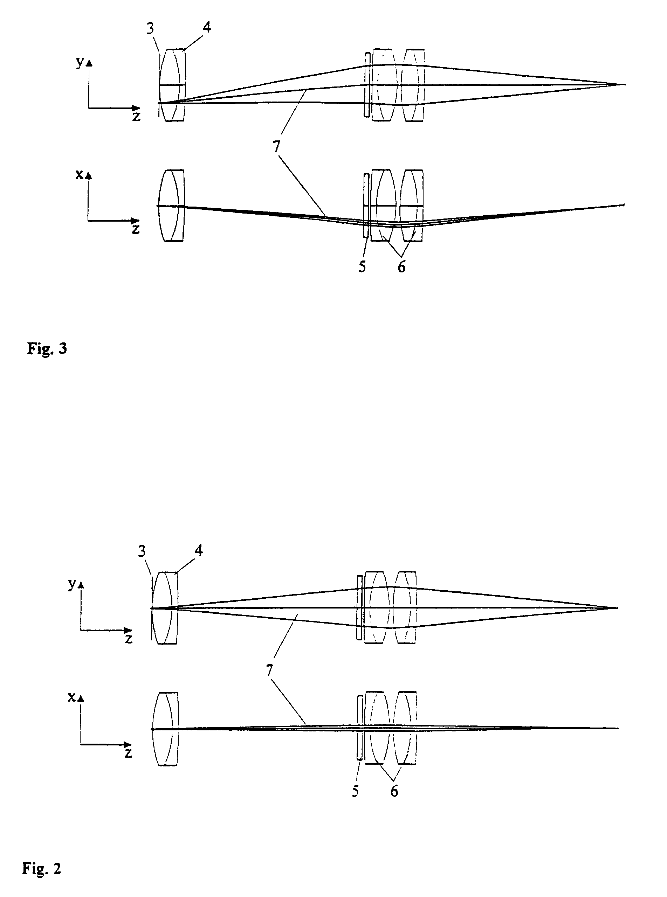

In Fig. 2 und Fig. 3 werden optische Strahlengänge dargestellt, die für das folgende Ausführungsbeispiel berechnet wurden. Zur Kollimation der stark divergenten Abstrahlrichtung (x-Richtung) und Ablenkung der kollimierten einzelnen Strahlbündel 7 ebenfalls in der x-Richtung wird eine gradientenoptische (GRIN) Zylindermikrolinse 3 verwendet, die in diesem Ausführungsbeispiel eine Abmessung in x-Richtung von 300 µm aufweist. Durch Schrägstellen der gradientenoptischen Mikrozylinderlinse 3 in bezug auf den Laserdiodenbarren 1 durch eine Drehung um die z-Achse um etwa 1° werden die einzelnen Laserdioden 2 in bezug auf die optische Achse der Mikrozylinderlinse 3 unterschiedlich stark versetzt, und zwar so, daß die Mittenemitter bzw. die mittleren Laserdioden praktisch nicht, die Randemitter, d.h. die am Rande des Laserdiodenbarrens 1 liegenden Laserdioden 2, am stärksten außeraxial kollimiert werden. Dies führt zu einer Ablenkung der kollimierten Bündel bezüglich der z-Achse nach der Mikrozylinderlinse 3. Wie aus Fign. 2 und 3 jeweils in der unteren Darstellung zu erkennen ist, führt die außeraxiale Anordnung bei der verwendeten Mikrozylinderlinse 3 nicht zu einer Verschlechterung der Kollimation, was bei Asphären-Mikrozylinderlinsen möglich ist. In dem dargestellten Ausführungsbeispiel wird weiterhin für das Direktionselement 4 ein handelsüblicher Achromat mit einer Brennweite im Bereich 50 mm verwendet. Fign. 2 und 3 zeigen die unterschiedlichen Ablenkungen durch den Achromaten 4 für einen Mittenemitter und einen Randemitter, wobei in Fig. 2 die Strahlung für den Mittenemitter und in Fig. 3 die Strahlung für den Randemitter dargestellt ist. Der zusätzliche Linseneffekt (Divergenzreduktion) des Achromaten 4 ist nur von sekundärer Wirkung.

In der Ebene des Redirektionselementes 5 entstehen bei der konkreten Ausführungsform folgende Verhältnisse:
In der y-z-Ebene (obere Darstellungen in Fign. 2 und 3) liegen alle Strahlbündel 7 der Einzelemitter bzw. einzelnen Laserdioden 2 zentrisch. Die Einfallswinkel bezüglich der z-Achse liegen dabei zwischen 0° für den Mittenemitter und ± ungefähr 6° für die beiden Randemitter entsprechend der Breite des Laserdiodenbarrens 1 von 10 mm, d.h. die Randemitter liegen 5 mm außeraxial. Naturgemäß liegt die zentrische Lage der einzelnen Strahlbündel 7 dann vor, wenn die Redirektionsebene im Abstand der Brennweite hinter dem Achromaten 4 liegt. Bei der oben angegebenen typischen Divergenz der Ausgangsstrahlung der Laserdioden 2 in der y-z-Ebene von ungefähr 6° (halber Öffnungswinkel) ergibt sich eine Bündelbreite in y-Richtung in der Redirektionsebene von etwa 10 mm.

In der x-z-Ebene (untere Darstellungen in Fign. 2 und 3) ergeben sich auf dem Redirektionselement 5 für die oben angegebenen Abmessungen und Abstände eine Breite der Strahlbündel der einzelnen Emitter bzw. Laserdioden 2 von ungefähr 0,5 bis 0,6 mm, je nach tatsächlicher Emitterdivergenz in dieser Ebene. Um zum Beispiel für einen Laserdiodenbarren 1 mit 16 Emittern die zugehörigen einzelnen Strahlbündel trennen und separat umlenken zu können, ist ein Abstand der Bündelschwerpunkte in x-Richtung von 0,6 mm notwendig. Dies bedeutet, daß die beiden Strahlbündel der Randemitter in der x-Richtung um etwa ± 6° ausgelenkt werden müssen (siehe Fig. 3). Dies erfordert die oben erwähnte Schrägstellung der Mikrozylinderlinse 3 um ungefähr 1°. Die Gesamtausdehnung der Ausgangsstrahlung der Laserdioden in x-Richtung beträgt dann etwa 10 mm (16 Emitter x 0,6 mm).

Im Ergebnis entsteht in der Redirektionsebene ein nahezu symmetrisches Gesamtbündel mit einem Bündelquerschnitt von 10 mm x 10 mm, bestehend aus einer Reihe von in x-Richtung übereinander angeordneten Einzelbündeln, die wiederum den in y-Richtung angeordneten einzelnen Emittern 2 des Laserdiodenbarrens 1 zuzuordnen sind, d.h. die Gesamtstrahlung in der x-y-Ebene besteht aus 16 übereinanderliegenden Strahlbündel der Abmessung in x-Richtung von 0,6 mm und in y-Richtung von 10 mm. Somit ist die für die nachfolgend vorgesehene effiziente Fokussierung notwendige Symmetrierung erreicht.

Das Redirektionselement 5 muß jedoch noch die in Fig. 1 oben dargestellten unterschiedlichen Einfallswinkel der Strahlbündel der einzelnen Laserdioden 2 in der y-z-Ebene korrigieren. Durch die in x-Richtung entsprechend Fig. 1 unten vorliegende räumliche Trennung der einzelnen Strahlbündel kann die Korrektur in der Redirektionsebene prinzipiell realisiert werden, wobei für jedes einzelne Strahlbündel eine unterschiedliche Ablenkung notwendig ist. Im in Fign. 2 und 3 dargestellten Ausführungsbeispiel liegen diese Ablenkwinkel zwischen 0° für das Strahlbündel des Mittenemitters und 6° für die Strahlbündel der Randemitter. Entsprechend den Abmessungen der Strahlbündel in der Redirektionsebene müssen die einzelnen ablenkenden Bereiche dabei eine Breite von 0,6 mm in x-Richtung und mindestens 10 mm in y-Richtung aufweisen. Im Ausführungsbeispiel wird anstelle des klassischen Aufbaus mit 16 schmalen prismatischen Körpern ein Gitterarray unter Nutzung der Möglichkeiten der Mikrostrukturierung aus 16 unterschiedlich ablenkenden schmalen Bereichen verwendet, wobei eine Realisierung des Gitterarrays mit den geforderten maximalen Ablenkwinkeln von nur 6° Gitterperioden technisch relativ einfach möglich ist.

Für die abschließende Fokussierung des Gesamtbündels in einen möglichst kleinen Fleck werden im Ausführungsbeispiel zwei handelsübliche Achromaten mit Brennweiten von 50 mm und 60 mm verwendet. Mit dieser Fokussieroptik 6 werden Bündelbreiten im Fokus von etwa 0,2 x 0,2 mm erzeugt, und zwar mit einer Konvergenz des Bündels von etwa 6° halber Öffnungswinkel. Bei stärkerer Fokussierung wird das Bündel im Fokus entsprechend kleiner.

Die Fokussieroptik 6 kann auch aus zwei Linsen gebildet werden, zwischen denen das Redirektionselement 5 angeordnet ist.

Zur Verbesserung der Abbildungseigenschaften der optischen Anordnung kann dem Redirektionselement 5 ein Feld von in der xz-Ebene wirksamen Zylinderlinsen so vor- oder nachgeschaltet werden, daß jedem Bereich des Redirektionselementes 5 eine Zylinderlinse zugeordnet ist, deren Breite in der x- bzw. y-Richtung der Breite der Ablenkbereiche des Ablenkgitterfeldes bzw. der Prismen des Prismenfeldes bzw. der Spiegel des Spiegelfeldes entspricht.

## Patentansprüche

1. Optische Anordnung zur Symmetrierung der Strahlung einer Mehrzahl von in fester Zuordnung in y-Richtung nebeneinander angeordneten Laserdioden, die in z-Richtung abstrahlen und deren Abstrahlung in der xz- und yz-Ebene unsymmetrisch ist, wobei den Laserdioden eine Zylinderlinsenoptik nachgeschaltet ist,
**dadurch gekennzeichnet,**
**daß** die Zylinderlinsenoptik (3) um die optische Achse (z-Achse), die senkrecht zu der xy-Ebene steht, gekippt angeordnet ist und die Ausgangsstrahlbündel der einzelnen Laserdioden in die x-Richtung kollimiert und zueinander versetzt und dabei trennt, daß der Zylinderlinsenoptik (3) ein erstes Ablenkelement (4) nachgeschaltet ist, das die Strahlbündel der einzelnen Laserdioden (2) in der y-Richtung mit jeweils unterschiedlichen Ablenkwinkeln derart umlenkt, daß in einem vorgegebenen Abstand die Schwerpunkte der einzelnen Strahlbündel in y-Richtung zusammenfallen und daß im Abstand hinter dem ersten Ablenkelement (4) ein zweites Ablenkelement (5) angeordnet ist, das die unterschiedlichen Ablenkwinkel der Strahlbündel zur optischen Achse (z-Achse) wieder kompensiert.

2. Anordnung nach Anspruch 1, **dadurch gekennzeichnet, daß** dem zweiten Ablenkelement (5) eine Fokussieroptik (6) nachgeschaltet ist, die die durch das zweite Ablenkelement hindurchtretenden Strahlenbündel auf einen Strahlungsfleck geringer Abmessung konzentriert.

3. Anordnung nach Anspruch 1 oder 2, **dadurch gekennzeichnet, daß** die Zylinderlinsenoptik (3) eine gradientenoptische Mikrozylinderlinse (GRIN), eine Asphären-Mikrozylinderlinse, eine Fresnellinse, eine Plankonvex- und Bikonvexlinse und/oder eine Kombination derselben aufweist.

4. Anordnung nach Anspruch 3, **dadurch gekennzeichnet, daß** die gradientenoptische Mikrozylinderlinse ein in die erste Richtung eindimensionales Brechzahlprofil aufweist.

5. Anordnung nach Anspruch 3, **dadurch gekennzeichnet, daß** die gradientenoptische Mikrozylinderlinse ein zweidimensionales Brechzahlprofil aufweist.

6. Anordnung nach einem der Ansprüche 1 bis 5, **dadurch gekennzeichnet, daß** das erste Ablenkelement (4) als Achromat oder als Bikonvex- oder Plankonvexlinse mit sphärischen oder asphärischen Oberflächen oder als Bikonvex- oder Plankonvex-Zylinderlinse ausgebildet ist.

7. Anordnung nach einem der Ansprüche 1 bis 6, **dadurch gekennzeichnet, daß** das zweite Ablenkelement (5) als Feld von Ablenkgittern ausgebildet ist.

8. Anordnung nach einem der Ansprüche 1 bis 6, **dadurch gekennzeichnet, daß** das zweite Ablenkelement (5) als Prismenfeld ausgebildet ist.

9. Anordnung nach einem der Ansprüche 1 bis 6, **dadurch gekennzeichnet, daß** das zweite Ablenkelement (5) als Spiegelfeld ausgebildet ist.

10. Anordnung nach einem der Ansprüche 7 bis 9, **dadurch gekennzeichnet, daß** die Ablenkbereiche bzw. Prismen bzw. Spiegel mit jeweils unterschiedlichen Ablenkwinkeln des Ablenkgitterfeldes bzw. des Prismenfeldes bzw. des Spiegelfeldes in der x-Richtung nebeneinander angeordnet sind.

11. Anordnung nach Anspruch 10, **dadurch gekennzeichnet, daß** die Breite der Ablenkbereiche bzw. der Prismen bzw. der Spiegel in der x-Richtung dem Abstand der Schwerpunkte der Strahlbündel in x-Richtung auf der Ebene des zweiten Ablenkelementes (5) entsprechen.

12. Anordnung nach Anspruch 11, **dadurch gekennzeichnet, daß** dem zweiten Ablenkelement (5) ein Feld von in der xz-Ebene wirksamen Zylinderlinsen, deren Breite in der x- bzw. der y-Richtung der Breite der Ablenkbereiche bzw. der Prismen bzw. der Spiegel in der x- bzw. y-Richtung entspricht, so vor- oder nachgeschaltet wird, daß jedem Bereich des zweiten Ablenkelements (5) eine Zylinderlinse zur Verbesserung der Abbildungseigenschaften der Anordnung zugeordnet ist.

13. Anordnung nach einem der Ansprüche 1 bis 12, **dadurch gekennzeichnet, daß** die Fokussieroptik (6) aus zwei Linsen gebildet ist, zwischen denen das zweite Ablenkelement (5) angeordnet ist.

14. Anordnung nach einem der Ansprüche 1 bis 13, **dadurch gekennzeichnet, daß** die Fokussieroptik (6) aus Achromaten gebildet ist.

## Claims

1. Optical array for symmetrisation of beams of a plurality of laser diodes which are arranged in fixed association alongside each other in y-direction, which beam in z-direction and the output radiation of which in the xz- and yz-plane is asymmetrical, and downstream of the laser diodes is placed a cylindrical lens, **characterised in that** the cylindrical lens (3) is arranged so as to be tilted around the optical axis (z-axis) which is perpendicular to the xy-plane, and collimates the output beam bundles of the individual laser diodes in x-direction and offsets them relative to each other whilst separating them, that downstream of the cylindrical lens (3) is a first deflecting element (4) which deflects the beam bundles of the individual laser diodes (2) in y-direction with respective differing deflecting angles in such a manner that the centres of gravity of the individual beam bundles coincide at predetermined spacing in y-direction and at a distance behind the first deflecting element (4) is arranged a second deflecting element (5) which again compensates the different deflecting angles of the beam bundles relative to the optical axis (z-axis).

2. Array according to Claim 1, **characterised in that** downstream of the second deflecting element (5) is a focal lens (6) which concentrates beam bundles passing through the second deflecting element onto a beam spot of small dimension.

3. Array according to Claim 1 or 2, **characterised in that** the cylindrical lens (3) comprises a gradient-optical micro-cylinder lens (GRIN), an aspherical micro-cylinder lens, a Fresnel lens, a plane-convex and bi-convex lens and/or a combination thereof.

4. Array according to Claim 3, **characterised in that** the gradient-optical micro-cylinder lens has a refractory number profile which is one-dimensional in the first direction.

5. Array according to Claim 3, **characterised in that** the gradient-optical micro-cylinder lens has a two-dimensional refractory number profile.

6. Array according to one of Claims 1 to 5, **characterised in that** the first deflecting element (4) is designed as an achromatic or bi-convex or plane-convex lens with spherical or aspherical surfaces or as bi-convex or plane-convex cylinder lens.

7. Array according to one of Claims 1 to 6, **characterised in that** the second diverting element (5) is designed as a field of diverting grids.

8. Array according to one of Claims 1 to 6, **characterised in that** the second diverting element (5) is designed as a prism field.

9. Array according to one of Claims 1 to 6, **characterised in that** the second diverting element (5) is designed as a mirror field.

10. Array according to one of Claims 7 to 9, **characterised in that** the diverting areas or prisms or mirrors are configured alongside each other with respectively different diverting angles of the diverting grid field or the prism field or the mirror field in the x-direction.

11. Array according to Claim 10, **characterised in that** the width of the diverting areas or the prisms or the mirrors in the x-direction correspond with the distance of the points of gravity of the beam bundles in the x-direction on the plane of the second diverting element (5).

12. Array according to Claim 11, **characterised in that** upstream or downstream of the second diverting element (5) is a field of cylindrical lenses operative in the xz-plane, the width of which corresponds in the x- or y-direction with the width of the diverting areas or the prisms or the mirrors in the x- or y-direction, so that each area of the second deflecting element (5) is associated with a cylindrical lens for the purpose of improving the imaging properties of the array.

13. Array according to one of Claims 1 to 12, **characterised in that** the focusing lens (6) is composed of two lenses with a deflecting element (5) thereinbetween.

14. Array according to one of Claims 1 to 13, **characterised in that** the focusing lens (6) is composed of achromats.

## Revendications

1. Dispositif optique de symétrisation du faisceau d'un certain nombre de diodes laser, disposées les unes à côté des autres selon une disposition fixe dans la direction y, qui émettent dans la direction z et dont le rayonnement est asymétrique dans les plans xz et yz, dans lequel une optique à lentille cylindrique est intercalée à la suite des diodes laser, **caractérisé en ce que** l'optique à lentille cylindrique (3) est disposée de façon basculée autour de l'axe optique (axe z), qui est perpendiculaire au plan xy, et les faisceaux d'émission en sortie des différentes diodes laser sont collimatés dans la direction x et décalés les uns par rapport aux autres et à cet égard séparés, **en ce qu'**un premier élément de déviation (4) est intercalé après l'optique à lentille cylindrique (3), lequel élément dévie le faisceau d'émission des différentes diodes laser (2) dans la direction y selon des angles de déflexion respectivement différents de façon telle que, à un écart prédéfini, les barycentres des différents faisceaux d'émission coïncident dans la direction y et que, à un écart derrière le premier élément de déviation (4) est disposé un second élément de déviation (5) qui compense à nouveau les différents angles de déflexion des faisceaux d'émission par rapport à l'axe optique (axe z).

2. Dispositif selon la revendication 1, **caractérisé en ce qu'**une optique de focalisation (6) est intercalée après le second élément de déviation (5), laquelle concentre le faisceau d'émission traversant le second élément de déviation sur une tache de rayonnement de dimension moindre.

3. Dispositif selon la revendication 1 ou 2, **caractérisé en ce que** l'optique à lentille cylindrique (3) présente une microlentille GRIN, une microlentille cylindrique non sphérique, une lentille de Fresnel, une lentille plan-convexe et une lentille biconvexe, et/ou une combinaison de celles-ci.

4. Dispositif selon la revendication 3, **caractérisé en ce que** la microlentille cylindrique GRIN présente un profil d'indice de réfraction unidimensionnel dans la première direction.

5. Dispositif selon la revendication 3, **caractérisé en ce que** la microlentille cylindrique GRIN présente un profil d'indice de réfraction bidimensionnel.

6. Dispositif selon l'une des revendications 1 à 5, **caractérisé en ce que** le premier élément de déviation (4) est conçu en tant qu'achromat ou en tant que lentille biconvexe ou plan-convexe présentant des surfaces sphériques ou non sphériques ou en tant que lentille cylindrique biconvexe ou plan-convexe.

7. Dispositif selon l'une des revendications 1 à 6, **caractérisé en ce que** le second élément de déviation (5) est conçu en tant que champ de réseaux de déviation.

8. Dispositif selon l'une des revendications 1 à 6, **caractérisé en ce que** le second élément de déviation (5) est conçu en tant que champ de prismes.

9. Dispositif selon l'une des revendications 1 à 6, **caractérisé en ce que** le second élément de déviation (5) est conçu en tant que champ de miroirs.

10. Dispositif selon l'une des revendications 7 à 9, **caractérisé en ce que** les zones de déviation ou prismes ou miroirs présentant des angles de déflexion respectivement différents du champ de réseaux de déviation ou du champ de prismes ou du champ de miroirs sont disposés les uns à côté des autres dans la direction x.

11. Dispositif selon la revendication 10, **caractérisé en ce que** la largeur des zones de déviation ou des prismes ou des miroirs dans la direction x correspond à l'écart entre les barycentres des faisceaux d'émission dans la direction x sur le plan du second élément de déviation (5).

12. Dispositif selon la revendication 11, **caractérisé en ce qu'**un champ de lentilles cylindriques efficaces dans le plan xz, et dont la largeur dans la direction x ou la direction y correspond à la largeur des zones de déviation ou des prismes ou des miroirs dans la direction x ou y, est intercalé avant ou après le second élément de déviation (5), de façon telle qu'à chaque zone du second élément de déviation (5) est coordonnée une lentille cylindrique permettant d'améliorer les propriétés d'image du dispositif.

13. Dispositif selon l'une des revendications 1 à 12, **caractérisé en ce que** l'optique de focalisation (6) se compose de deux lentilles, entre lesquelles est disposé le second élément de déviation (5).

14. Dispositif selon l'une des revendications 1 à 13, **caractérisé en ce que** l'optique de focalisation (6) est formée d'achromats.
